Europäisches Patentamt

European Patent Office

Office européen des brevets

(11) Numéro de publication: **0 236 213 B1**

# FASCICULE DE BREVET EUROPEEN

(45) Date de publication du fascicule du brevet:
**19.12.90**

(21) Numéro de dépôt: **87400372.6**

(22) Date de dépôt: **20.02.87**

(51) Int. Cl.⁵: **H05K 13/04, H01F 41/06**

(54) **Procédé automatique de fabrication et d'implantation de bobinages sans carcasse support sur un circuit imprimé, et machine de mise en oeuvre.**

(30) Priorité: **25.02.86 FR 8602584**

(43) Date de publication de la demande:
**09.09.87 Bulletin 87/37**

(45) Mention de la délivrance du brevet:
**19.12.90 Bulletin 90/51**

(84) Etats contractants désignés:
**AT BE CH DE IT LI LU**

(56) Documents cités:
**EP-A- 0 016 984**
**DE-A- 2 363 626**
**FR-A- 2 293 998**
**FR-A- 2 354 620**
**GB-A- 956 110**
**US-A- 3 945 100**

(73) Titulaire: **OREGA ELECTRONIQUE & MECANIQUE, 74, rue du Surmelin, F-75020 Paris(FR)**

(72) Inventeur: **Begin, Bernard, THOMSON-CSF SCPI-19, avenue de Messine, F-75008 Paris(FR)**
Inventeur: **Briotet, Jacques, THOMSON-CSF SCPI-19, avenue de Messine, F-75008 Paris(FR)**
Inventeur: **Turpin, Jacques, THOMSON-CSF SCPI-19, avenue de Messine, F-75008 Paris(FR)**

(74) Mandataire: **Chaverneff, Vladimir et al, THOMSON-CSF SCPI, F-92045 PARIS LA DEFENSE CEDEX 67(FR)**

ACTORUM AG

## Description

La présente invention se rapporte à un procédé automatique de fabrication et d'implantation automatique de bobinages sans carcasse support sur un circuit imprimé, et à une machine de mise en oeuvre de ce procédé.

Actuellement, pour implanter, lors d'une fabrication en série, sur un circuit imprimé des bobinages sans carcasse support (généralement appelés "selfs à air"), on procède manuellement du fait qu'aucun procédé connu de fabrication de ces bobinages ne permet de garantir un écartement mutual invariable des "pattes" (extrémités de leurs connexions) de ces bobinages, pattes qui doivent être introduites dans des trous à entraxe bien précis et à diamètre égal ou légèrement supérieur à celui des pattes. Ceci tient en particulier au fait que les bobinages, bien que réalisés en fil de cuivre, se comportent en ressorts hélicoïdaux, dans une faible mesure, mais suffisante pour empêcher leurs pattes de garder l'orientation acquise à la fin du bobinage.

La présente invention a pour objet un procédé automatique de fabrication et d'implantation de bobinages du type précité, qui permette de garantir un écartement précis des pattes des bobinages, et une implantation rapide de ces bobinages sur un circuit imprimé.

La présente invention a également pour objet une machine de mise en oeuvre de ce procédé.

Le procédé de l'invention est défini dans la revendication 1.

La machine de fabrication et d'implantation de bobinages conforme à l'invention est définie dans la revendication 5. GB-A 956 110 décrit un procédé de traitement automatique de bobinages sans carcasse support sur un appareil à tambour.

La présente invention sera mieux comprise à la lecture de la description détaillée d'un mode de réalisation, pris comme exemple non limitatif et illustré par le dessin annexé, sur lequel :

- la figure 1 est une vue schématique de dessus d'une installation, conforme à l'invention, de fabrication de bobinages et d'implantation de ces bobinages sur les circuits imprimés,
- la figure 2A est une vue simplifiée, en perspective, d'un tambour de bobinage de l'installation de la figure 1,
- les figures 2B à 2D sont respectivement une vue d'ensemble et deux vues de détails d'une variante du tambour de la figure 2A, équipé de plots pour le guidage et le maintien du fil,
- la figure 3 est une vue de côté, du dispositif de bobinage de l'installation de la figure 1, montrant le tambour de bobinage et, en coupe partielle, le "flyer" de bobinage coopérant avec ce tambour, et
- la figure 4 est une vue de côté d'une variante simplifiée du dispositif de coupe de fil de l'installation de la figure 1, et
- la figure 5 est une vue en perspective du principe de l'outil de coupe de fil et de transfert.

L'installation décrite ci-dessous, en référence au dessin, fait partie d'un équipement de fabrication de "tuners" (circuits d'entrée et hétérodynes) miniaturisés pour récepteurs de télévision, mais il est bien entendu que l'invention n'est pas limitée à une telle application, et peut être utilisée dans la plupart des cas où l'on veut implanter automatiquement des bobinages sans carcasse-support sur un circuit imprimé.

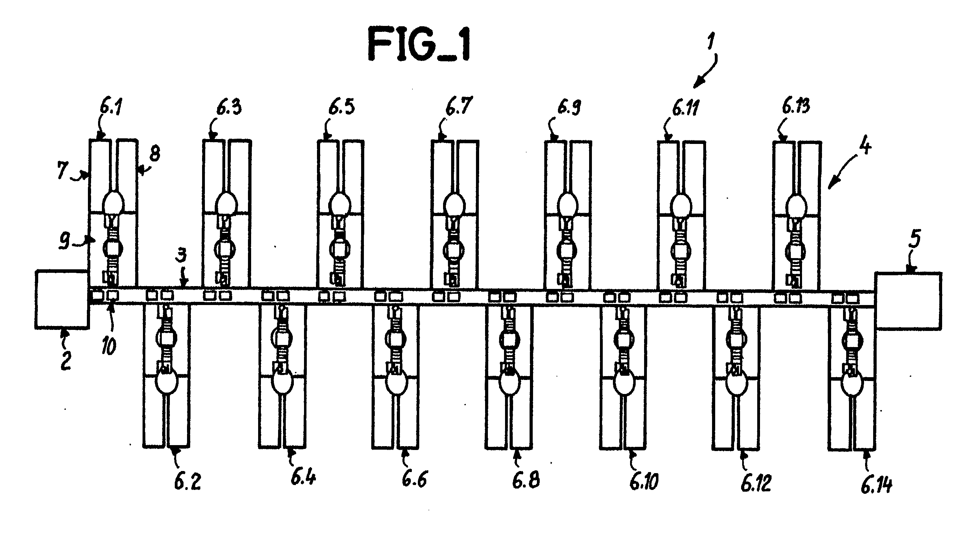

L'installation 1 représentée sur la figure 1 est chargée de fabriquer et d'implanter vingt-huit bobinages sans carcasse-support (généralement appelés "selfs à air"), presque tous différents, sur un circuit imprimé de tuner. Bien entendu, ce nombre de vingt-huit n'est nullement limitatif. Ces bobinages sont, dans le présent exemple, du type à connexions parallèles entre elles et partant tangentiellement du corps de bobinage, dans le même sens toutes deux.

L'installation 1 comprend essentiellement un poste 2 de chargement, un convoyeur 3, quatorze postes de travail doubles référencés 4 dans leur ensemble et un poste de déchargement 5.

Le poste 2 reçoit, par tout moyen approprié (non représenté), par exemple depuis un convoyeur, des circuits imprimés de tuner munis de tous leurs composants discrets, ou d'une partie de ces composants, à l'exception des bobinages, en provenance d'une unité d'implantation de tels composants (non représentée). Dans ce poste 2, les circuits imprimés étant convenablement orientés, un automate dépose un petit point de colle à prise différée à chaque emplacement de bobinage. Ce point de colle est disposé pour chaque emplacement, sensiblement à mi-chemin des trous de passage des connexions du bobinage correspondant, dans l'alignement de ces trous. Les dimensions de ce point de colle sont telles que ce point soit en contact en au moins un endroit avec le fil du bobinage lorsque les connexions de ce dernier sont introduites dans les trous correspondants et que ce bobinage arrive au contact de la surface du circuit imprimé, et ce, quel que soit le pas du bobinage. La colle utilisée est du type à prise différée, de préférence à polymérisation à chaud ou aux ultra-violets, pour permettre l'implantation de tous les bobinages, sur le trajet du convoyeur 3, avant sa prise à la sortie de ce convoyeur, quel que soit le temps de trajet de ce convoyeur (dans des limites raisonnables, bien entendu).

Dans le cas de bobinages spéciaux, à une seule spire ou à pas très grand par exemple, on peut modifier en conséquence l'emplacement du point de colle et/ou son volume, mais dans la plupart des cas, il est plus simple et il suffit de déposer des points de colle identiques aux emplacements précités.

Une fois tous les points de colle déposés, le poste 2 dépose les circuits imprimés, convenablement orientés, sur le convoyeur 3.

L'ensemble 4 comporte, comme précisé ci-dessus, quatorze poste de travail doubles, référencés 6.1 à 6.14, et disposés en quinconce de part et d'autre du convoyeur rectiligne 3, afin de diminuer l'encombrement de l'installation 1. On pourraît, bien entendu, adopter une autre forme de convoyeur et/ou une autre disposition des postes de travail et/ou utiliser des postes de travail simples ou multiples (triples, quadruples...).

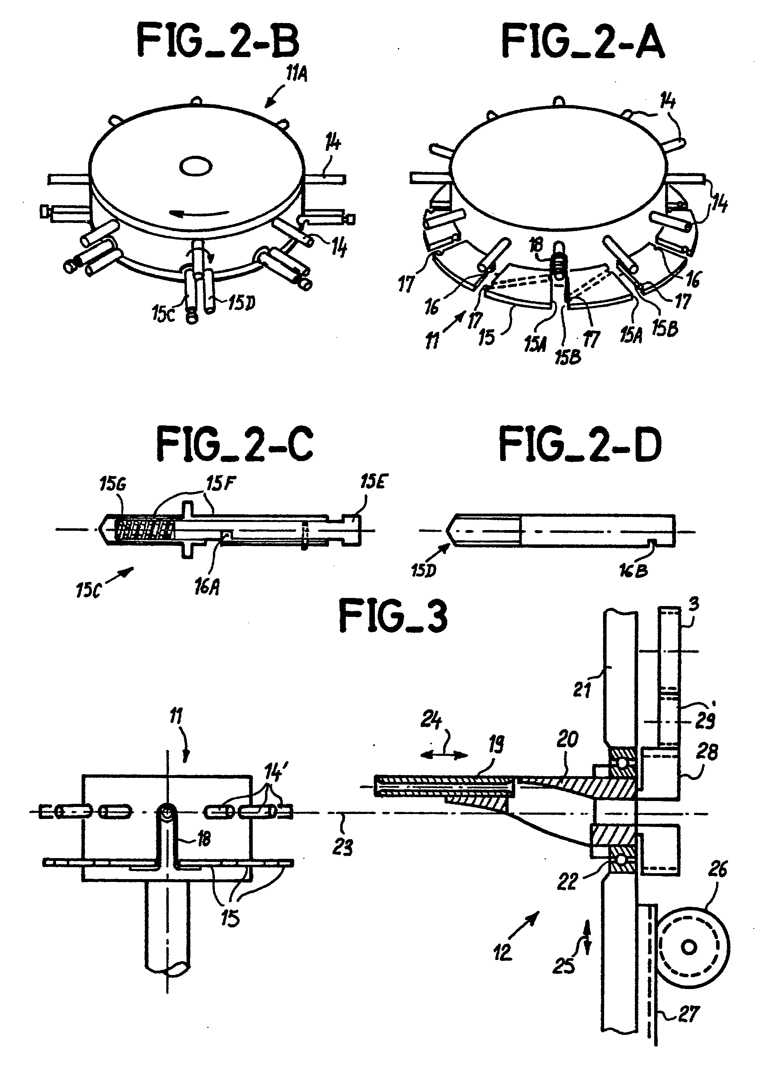

Chaque poste de travail double comporte deux stations de bobinage (par exemple le poste 6.1 qui comporte les deux stations 7,8) et un robot de manipulation (référencé 9 pour le poste 6.1). Une station de bobinage sera décrite en détail ci-dessous, en référence aux figures 2A à 5. Un robot, tel que le robot 9, est chargé de prélever alternativement les bobinages sur l'outil de coupe et de transfert de chacune des deux stations de bobinage associées (stations 7 et 8 pour le robot 9) et de les implanter sur les circuits imprimés lorsque le convoyeur 3 les arrête à la hauteur du robot (par exemple circuit imprimé 10 pour le robot 9 sur la figure 1). Ce robot saisit les bobinages présentés par l'outil de coupe et de transfert, par leurs connexions. Etant donné que la réalisation d'un tel robot est évidente pour l'homme de l'art, il ne sera pas décrit plus en détail.

Dans la station 5, on installe un dispositif de polymérisation de la colle déposée dans la station 2, afin de bien maintenir en place tous les bobinages insérés sur les circuits imprimés par les robots des postes de travail 6.1 à 6.14. Ce dispositif de polymérisation peut par exemple être un four. La polymérisation peut se faire au défilé sur le convoyeur 3, ou bien les circuits imprimés peuvent être chargés sur des rayonnages ou palettes fixes du dispositif de polymérisation pour être déchargés après traitement. Les circuits imprimés munis de leurs bobines sont ensuite extraits de la station 5, par exemple par ruban convoyeur et sont acheminés vers un poste de soudage (non représenté) de composants.

On va maintenant décrire, en référence aux figures 2A à 5, une station de bobinage conforme à l'invention. Une telle station comporte essentiellement un tambour de bobinage 11, un "flyer" de bobinage 12, un dispositif 13 de coupe de connexions, et un dispositif d'approvisionnement en fil de bobinage (non représenté).

Le tambour de bobinage 11 se présente effectivement sous la forme d'un tambour, tournant autour de son axe disposé verticalement de préférence. On fixe sur la surface latérale périphérique de ce tambour plusieurs, par exemple douze, broches de bobinage 14 qui sont avantageusement amovibles et interchangeables. Le diamètre de ces broches correspond au diamètre intérieur des bobinages à réaliser dans la station en question. De préférence, on ne réalise qu'un seul type de bobinage par tambour, afin de ne pas compliquer le processus de fabrication, et on utilise autant de tambours, donc de stations de bobinage, qu'il faut réaliser de bobinages différents.

Toutefois selon une variante de l'invention (non représentée) mise en oeuvre s'il faut réaliser peu de bobinages différents, on utilise un seul tambour de bobinage, donc une seule station de bobinage, ce tambour étant muni d'autant de broches différentes qu'il y a de types de bobinages à réaliser pour un circuit, ces broches ayant des dimensions appropriées aux bobinages, la station comportant autant de "flyers" différents qu'il y a de fils de diamètres différents, ainsi qu'un dispositif de coupe et de transfert réglable en fonction des différents diamètres de bobinages, ou bien autant de dispositifs de coupe et de transfert différents qu'il y a de diamètres de bobinage, et l'automate de manipulation et d'insertion étant programmé, de façon connue en soi, pour s'adapter à ces différents bobinages et pour les implanter à des endroits différents d'un même circuit.

Les axes des broches 14 s'étendent radialement et sont tous dans un même plan, à la partie supérieure du tambour 11, et sont régulièrement espacés. Les longueurs des broches 14 sont fonction de la longueur axiale des bobinages à réaliser, et sont, bien entendu, légèrement supérieures à cette dernière pour faciliter le bobinage.

Le tambour 11 comporte, à la partie inférieure de sa surface latérale périphérique des ailettes 15 régulièrement espacées, en forme de secteurs coplanaires de couronne plane. Le plan de ces secteurs est perpendiculaire à l'axe du tambour, et leur nombre est égal à celui des broches. La longueur des ailettes 15, mesurée dans le sens radial, est pratiquement égale à celle des broches 14. Les bords 15A, 15B se faisant face de deux ailettes consécutives sont parallèles entre eux et sont équidistants par rapport à un plan passant par l'axe du tambour et l'axe de la broche la plus proche de ces deux bords.

Ces ailettes sont équipées d'un dispositif de maintien du fil (non représenté) afin d'éviter le désenroulement après l'opération de coupe qui sera décrite plus loin, et un dispositif d'éjection de la chute de fil entre deux selfs, après l'opération de coupe. Dans la variante du tambour 11A des figures 2B à 2D, les ailettes sont remplacées par des plots 15C, 15D disposés parallèlement à la broche de bobinage 14. Ces plots sont munis d'encoches 16A, 16B pour le guidage du fil (identiques à 16 et 17 respectivement), et les plots 15C sont munis d'un dispositif à poussoir 15E pour le maintien du fil. Le dispositif 15E est actionné par une came (non représentée) lors du passage sous la tête de bobinage. Ce dispositif 15E coulisse dans un manchon 15F fixé sur la tambour 11A. Au repos, sous l'action d'un ressort 15G, qui tend à éloigner le poussoir 15E du tambour, l'encoche 16A de ce poussoir est obturée par le manchon 15F, et sous l'action de ladite came, cette encoche est dégagée et guide le fil de bobinage qui est coincé entre le manchon et le poussoir dès que cette came n'agit plus.

Dans chacun des bords rectilignes 15A, 15B d'une ailette 15 on pratique une encoche rectiligne 16, 17 respectivement, de section semi-circulaire, d'axe parallèle à l'axe du tambour 11, et de rayon par exemple égal au rayon du fil de bobinage. L'une des encoches 16 est pratiquée près de la surface périphérique du tambour 11 dans l'un des bords par exemple 15A, et l'autre encoche 17 est pratiquée dans l'autre bord 15B vers l'extrémité libre de ce bord, et ce, de la même façon pour chaque ailette pour que chaque ensemble de deux bords 15A, 15B se faisant face comporte une encoche 16 et une encoche 17. L'entraxe des encoches d'un tel ensemble est égal à l'entraxe d'insertion dans le circuit imprimé des connexions d'un bobinage à réaliser. Lorsque, comme précisé ci-dessus, on réalise des bobinages dont les connexions, parallèles entre elles, partent tangentiellement du corps du bobinage, dans le même sens, la distance entre les bords 15A, 15B se faisant face est égale au diamètre des broches 14 augmenté du diamètre du fil de bobinage (si le rayon des encoches 16 , 17 est égal au rayon du fil de bobinage).

On a représenté sur les figures 2A et 3 une partie du fil de bobinage 18, après réalisation d'un bobinage, depuis une encoche 17 d'une ailette jusqu'à l'encoche 16 de l'ailette suivante (considérée dans le sens de déplacement du fil). Ce fil 18 passe depuis une première encoche 17 d'une première ailette 15 (encoche dans laquelle il arrive depuis la broche 14 la plus proche), sous cette ailette, puis passe dans l'encoche 16 de cette même ailette, monte, parallèlement à l'axe du tambour 11, vers la broche 14 correspondante sur laquelle il est bobiné en progressant vers l'extrémité de celle-ci, et à l'autre extrémité du bobinage, il descend vers l'encoche 17 de l'ailette suivante (celle dont le bord 15B est en vis-à-vis du bord 15A de ladite première ailette), parallèlement à l'axe du tambour 11, puis passe sous cette ailette suivante, vers l'encoche 16 de celle-ci.

On a représenté sur la figure 3, les parties essentielles du "flyer" 12, guidant le fil de bobinage, en vis-à-vis du tambour 11. Ce flyer étant d'un type connu en soi, ne sera décrit que brièvement. Le flyer 12 comporte une buse de guidage de fil 19 supportée par une embase 20, supportée elle-même par un plateau 21 par l'intermédiaire d'un roulement à billes 22 dont l'axe est dans le prolongement de l'axe 23 d'une broche 14 lorsque la rotation du tambour place cette dernière face au flyer 12, et que ce dernier est en position de bobinage. L'axe de la buse 19 est parallèle à l'axe du roulement 22, à une distance de ce dernier légèrement supérieure au rayon du bobinage à réaliser.

Le plateau 21 est mobile (flèche 24) dans le sens de l'axe du roulement 22 (grâce à des moyens connus en soi et non représentés), et est également mobile verticalement (flèche 25), c'est-à-dire dans le sens de l'axe du tambour 11, grâce à une roue dentée 26 (entraînée par un moteur du type pas à pas non représenté) engrenant avec une crémaillère 27 fixée verticalement sur le plateau 21. Ce dispositif à roue dentée et crémaillère peut être remplacé par un système pneumatique. L'embase 20 est solidaire d'une roue dentée 28, entraînée en rotation via un pignon intermédiaire 29 par un moteur à courant continu dont on n'a représenté que le pignon de sortie 30.

Pour réaliser le bobinage, en partant par exemple d'une encoche 17, le fil étant supposé maintenu en amont de cette encoche, le plateau 21 est amené en position basse, la buse 19 étant en position basse par rapport à son axe de rotation (l'axe du roulement 22). L'axe de la buse 19 est alors légèrement en-dessous du plan des faces inférieures des ailettes 15. On fait alors tourner le tambour 11 (dans le sens des aiguilles d'une montre dans le cas représenté sur le dessin) d'un angle égal à l'angle au centre déterminé par les axes de deux broches 14 successives. Le plateau 21 est alors remonté vers sa position haute (axe du roulement 22 confondu avec l'axe de la broche 14) et on fait tourner simultanément la buse autour de son axe de rotation de quelques degrés dans le sens (sens contraire des aiguilles d'une montre en regardant dans l'axe du tambour, sur le dessin) contraire de celui qu'on lui imprimera ensuite pour enrouler le corps du bobinage, afin qu'elle ne heurte pas la broche 14 sur laquelle va s'effectuer le bobinage. On fait ensuite tourner la buse 19 autour de son axe de rotation du nombre de tours désiré, on la fait s'arrêter en position basse par rapport à son axe de rotation, et on fait revenir le plateau 21 en position basse, ce qui fait que le fil de bobinage passe sensiblement à mi-chemin des bords 15A, 15B correspondants. Une rotation suivante du tambour 11 associée à un mouvement horizontal du flyer suivant l'axe du roulement 22, et en se rapprochant de l'axe du tambour d'une distance égale à l'entraxe de la self, applique alors le fil contre l'encoche 17 de l'ailette 15 suivante, et le cycle qui vient d'être décrit se répète.

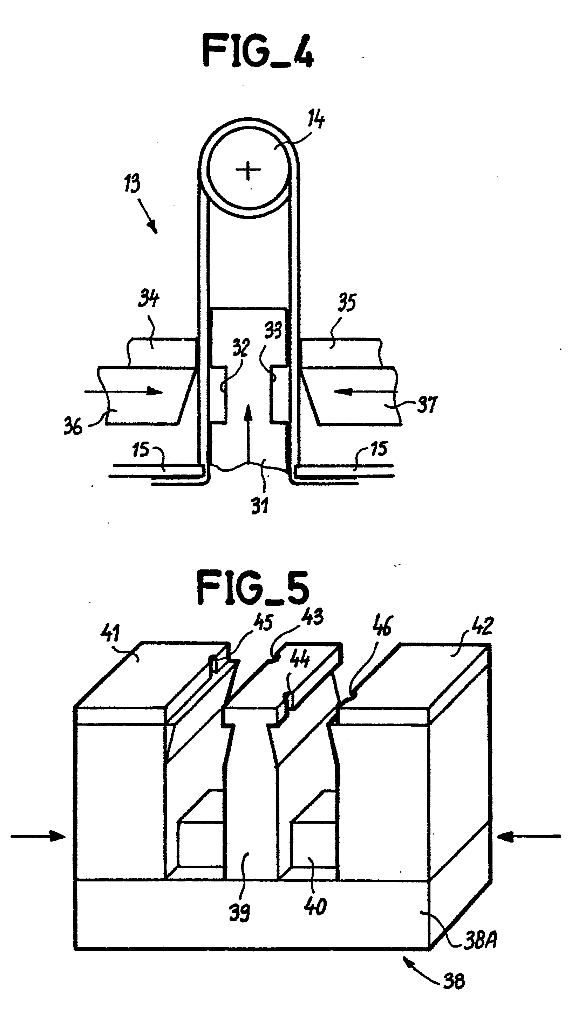

On a représenté sur la figure 4 le dispositif 13 de coupe des connexions des bobinages ainsi réalisés. Ce dispositif entre en action pendant la phase de bobinage, et s'efface lors du transfert de la self vers la pince de préhension du robot, permettant la rotation du tambour. Les connexions d'un bobinage ne sont pas coupées aussitôt après sa réalisation, mais après la réalisation du bobinage suivant, ou même de celui d'après, afin de garder une tension suffisante du fil, pour qu'en particulier les parties du fil comprises entre la broche 14 et les encoches 16, 17 des ailettes correspondantes restent parallèles entre elles.

Le dispositif de coupe 13 associé à l'outil de transfert de la figure 5, comporte une "enclume" mobile 31 en forme de plaque parallélépipédique dont la longueur du grand côté est sensiblement égale à celle des broches 14, dont la longueur du petit côté est très légèrement inférieure au diamètre des broches, et dont la hauteur est à peu près égale à la hauteur du tambour 11. L'enclume 31 est fixée sur un dispositif d'actionnement (non représenté) de façon que ses arêtes définissant sa hauteur restent verticales (ou tout au moins parallèles à l'axe du tambour 11). Ledit dispositif d'actionnement déplace l'enclume 31 presque au ras de la surface périphérique du tambour 11, entre deux bords 15A et 15B en vis-à-vis, et à égale distance de ceux-ci, lorsque le tambour 11 est à l'arrêt, et ce, d'une position basse pour laquelle la face supérieure (horizontale) de l'enclume se trouve en-dessous du plan des faces inférieures des ailettes 15, à une position haute pour laquelle la face supérieure de l'enclume arrive à proximité de la broche 14 correspondante.

L'enclume 31 comporte, sur chacun de ses grands côtés verticaux une rainure 32, 33 respectivement. Ces deux rainures, identiques, de section par exemple rectangulaire, s'étendent sur toute la longueur du côté, parallèlement à la face supérieure de l'enclume, toutes deux à la même distance de cette face, cette distance étant telle que lorsque l'enclume est en position haute, les arêtes supérieures de ces rainures arrivent dans le plan de coupe des connexions de la bobine réalisée sur la broche 14 correspondante.

L'enclume 31 coopère avec deux plaques mobiles 34, 35 appliquant le fil contre les parties supérieures des grands côtés de l'enclume, juste au-dessus des arêtes supérieures des rainures 32, 33. Les plaques 34, 35 de forme générale parallélépipédique, sont disposées et déplacées horizontalement (ou tout au moins perpendiculairement à l'axe du tambour 11) de façon que pour la phase de coupe leurs faces actives soient parallèles aux grands côtés de l'enclume et appliquent sur le brin de fil correspondant une pression modérée de maintien. Ces plaques sont actionnées par un dispositif d'actionnement (non représenté) qui ne les applique contre le fil à couper qu'au moment de la coupe, et du transfert de la self. Les petits côtés, parallèles à l'axe du tambour 11, des faces actives des plaques 34, 35, ont une longueur (déterminant l'épaisseur des plaques) égale ou inférieure à la hauteur desdites parties supérieures des grands côtés de l'enclume, et les grands côtés de ces faces actives ont une longueur égale à la longueur de l'enclume. Les plans des faces inférieures des plaques 34, 35 passent par les arêtes supérieures des rainures 32, 33.

La coupe est réalisée par des outils de coupe 36, 37 se déplaçant horizontalement sous les plaques 34, 35 pendant la phase de coupe, et s'effaçant également en-dehors de cette phase pour permettre la rotation du tambour. Ces outils 36, 37 se présentent comme des plaques de forme générale parallélépipédique disposées horizontalement en contact des faces inférieures des plaques 34, 35, et orientées dans le même sens que ces dernières. Seule la face active de chacun des outils 36, 37 est légèrement inclinée en formant avec la face supérieure correspondante un angle légèrement inférieur à 90°, tout en étant perpendiculaire aux faces latérales verticales adjacentes. L'arête horizontale supérieure de ces faces actives des outils 36 , 37 constitue l'arête de coupe qui sectionne le fil au niveau des faces inférieures des plaques 34 , 35, les outils étant déplacés l'un vers l'autre, en direction de l'enclume 31.

Le dispositif de coupe de l'invention permet de couper les connexions des bobinages sans les déformer ni modifier leur orientation grâce au fait que le fil de bobinage est tendu entre la broche et les encoches 16 , 17 correspondantes, et que l'enclume 31 et les plaques 34 , 35 maintiennent fermement les connexions au niveau du plan de coupe, permettant le maintien et le transfert de la self vers une pince automatique saisissant la self par les connexions, en assurant leur positionnement jusqu'à l'insertion dans les trous correspondants du circuit imprimé. On a représenté sur la figure 5 le principe d'un outil de coupe et de transfert 38. Cet outil est monté sur un bâti 38A sur lequel on fixe l'enclume 39, et perpendiculairement à cette enclume, à sa base, une glissière 40 sur laquelle se déplaçant deux mors 41, 42 assurant à la fois la coupe du fil et son maintien en fin de mouvement de coupe (les couteaux 36, 37 peuvent être solidaires des plaques 34, 35 et sont alors légèrement en saillie par rapport à ces plaques ; les mors 41, 42 sont équivalents à une telle configuration). A la partie supérieure de l'enclume 39, on pratique des encoches 43, 44 pour le passage et le guidage du fil de bobinage, et on pratique des encoches correspondantes 45, 46 dans les parties supérieures (au-dessus du plan de coupe) des mors 41, 42. Ces encoches, de section semicirculaire, à rayon égal à celui du fil de bobinage, maintiennent les extrémités des connexions du bobinage juste à la fin de la coupe du fil, lorsque les parties supérieures des mors 41, 42 arrivent au contact de la partie supérieure de l'enclume 39. L'outil 38 est alors éloigné du tambour (pour ne pas gêner sa rotation) et l'automate correspondant vient saisir avec une pince appropriée (non représentée) les connexions du bobinage, qu'il enlève dès que les mors 41, 42 s'écartent de l'enclume 39.

Ainsi après la coupe du fil, on obtient des bobinages dont l'orientation des connexions est rigoureusement définie. L'automate de manipulation des bobinages peut donc, à condition, bien entendu, de comporter des moyens de préhension ne déformant pas les connexions des bobinages, facilement introduire ces connexions dans les trous correspondants du circuit imprimé. Le collage des bobinages sur le circuit imprimé permet de les immobiliser pour effectuer d'autres manipulations du circuit, et le cas échéant l'implantation d'autres composants et/ou divers usinages avant l'étape de soudage sans risque de déplacement de ces bobinages. Toutes les étapes réalisées dans l'installation 1 sont automatisées, ce qui permet un gain de temps et de coût.

**Revendications**

1. Procédé automatique de fabrication et d'implantation de bobinages sans carcasse support sur un circuit imprimé, caractérisé par le fait que la buse (12) de bobinage du fil fait passer le fil de bobinage en un premier point fixe (16) faisant partie du tambour de bobinage (11, 11A), puis sur une broche (14) de diamètre approprié autour de laquelle la buse le bobine, puis en un deuxième point fixe (17) faisant également partie du tambour, la distance mutuelle de ces deux points fixes correspondant à l'entraxe d'insertion dans le circuit imprimé des extrémités rectilignes du bobinage appelées aussi connexions du bobinage, la distance de chacun d'eux par rapport à la broche étant légèrement supérieure à la longueur des connexions du bobinage à réaliser, leur disposition par rapport à la broche étant telle que ces connexions soient parallèles entre elles sur toute leur longueur, qu'un outil de coupe et de transfert coupe les connexions du bobinage à la longueur voulue, entre la broche et les deux points fixes, par cisaillage, en immobilisant le fil tendu dans la zone de cisaillage, que ledit outil enlève le bobinage de la broche, et qu'un automate de manipulation reprend la bobine par ses connexions puis insère les extrémités des connexions dans les trous correspondants du circuit imprimé.

2. Procédé selon la revendication 1, caractérisé par le fait que l'on dépose sur le circuit imprimé un point de colle entre les trous d'insertion pour les connexions d'un bobinage avant la mise en place du bobinage.

3. Procédé selon la revendication 2, caractérisé par le fait que la colle est du type à prise différée, dont la prise est déclenchée après la mise en place de tous les bobinages sans carcasse sur le circuit imprimé.

4. Procédé selon la revendication 3, caractérisé par le fait que la colle est une colle polymérisable à chaud, ou aux ultra-violets.

5. Machine automatique de fabrication et d'implantation de bobinages sans carcasse support, sur un circuit imprimé, caractérisée par le fait qu'elle comporte au moins une station de bobinage (7, 8) à buse de bobinage et à tambour (11, 11A) à broches (14) de bobinage, chaque broche étant associée à deux dispositifs de point fixe (15) faisant partie du tambour, un dispositif mobile de coupe de fil et de transfert (13) dont le plan de coupe est positionné à chaque fois entre une broche et les deux points fixes associés, et un automate de manipulation et d'insertion de bobinages (9) reprenant les bobinages par leurs extrémités rectilignes appelées aussi connexions.

6. Machine selon la revendication 5, caractérisée par le fait que les dispositifs de point fixe sont des ailettes coplanaires (ou des plots) (15) s'étendant perpendiculairement à l'axe du tambour, autour de sa face périphérique.

7. Machine selon la revendication 6, caractérisé par le fait que chaque ailette (ou plot) comporte une première encoche de guidage de fil (16) à proximité de la face périphérique du tambour déterminant l'emplacement de la première connexion du bobinage, et une seconde encoche de guidage de fil (17), plus éloignée de la face périphérique du tambour, déterminant l'emplacement de la seconde connexion du bobinage, ainsi qu'un dispositif de maintien du fil.

8. Machine selon l'une des revendications 5 à 7, caractérisée par le fait que la buse de bobinage du fil (12) peut se déplacer parallèlement à l'axe du tambour.

9. Machine selon l'une des revendications 5 à 8, caractérisée par le fait que le dispositif de coupe de fil comporte un dispositif (31, 34, 35) de serrage des connexions du bobinage, agissant au niveau du plan de coupe.

10. Machine selon l'une des revendications 5 à 9, caractérisée par le fait qu'elle comporte en outre un poste de dépôt de colle à prise différée sur les circuits imprimés (2) et un poste de prise de colle (5).

## Claims

1. An automatic method for the manufacture and implanting of windings not having support carcases onto a printed circuit, characterized in that the wire winding guide nozzle (12) moves the winding wire to a first fixed point (16) forming part of the winding drum (11 and 11A), then onto a spindle (14) with an appropriate diameter around which the guide nozzle winds it, then to a second fixed point (17) also forming part of the drum, the distance apart of these two fixed points corresponding to the center insertion distance in the printed circuit of the rectilinear ends of the winding also termed winding connections, the distance of each of the same with respect to the spindle being slightly greater than the length of the winding connections to be produced, their arrangement in relation to the spindle being such that these connections are parallel to each other along the entire length thereof, in that a cutting and transfer tool cuts the connections of the winding to the desired length between the spindle and the two fixed points by shearing, the taut wire being held stationary in the zone of shearing, in that the said tool doffs the winding from the spindle and in that an automatic manipulator grasps the winding by its connections and inserts the ends of the connections in the corresponding holes in the printed circuit.

2. The method as claimed in claim 1, characterized in that a blob of adhesive on the printed circuit between the holes for the connection of a winding prior to putting the latter in place.

3. The method as claimed in claim 2, characterized in that the adhesive is of the delayed cure type, setting being caused after the putting in place of all the windings without a support carcase on the printed circuit.

4. The method as claimed in claim 3, characterized in that the adhesive is one adapted to cure on heating or under the action of UV radiation.

5. An automatic machine for the manufacture and implantation of windings without a support carcase on a printed circuit, characterized in that it comprises at least one winding station (7 and 8) with a winding guide nozzle and with a drum (11 and 11A) with winding spindles (14), each spindle being associated with two devices having fixed point (15) forming part of the drum, a mobile device (13) for cutting the wire and for transfer, the plane of cutting thereof being positioned at each time between a spindle and the two associated fixed points, and an automatic manipulator and winding inserter (9) grasping the windings at the rectilinear ends also termed connections.

6. The machine as claimed in claim 5, characterized in that the fixed point devices are coplanar wings (or studs, 15) extending perpendicularly to the axis of the drum and around its peripheral surface.

7. The machine as claimed in claim 6, characterized in that each wing (or stud) comprises a first wire guide notch (16) in the proximity of the peripheral face of the drum setting the place of the first connection of the winding, and a second wire guide notch (17), further removed from the peripheral face of the drum, setting the place of the second winding connection, and also a device for supporting the wire.

8. The machine as claimed in any one of the claims 5 to 7, characterized in that the winding guide nozzle for the wire (12) is able to be moved in parallelism to the axis of the drum.

9. The machine as claimed in any one of the preceding claims 5 through 8, characterized in that the device for cutting the wire comprise a gripping device (31, 34 and 35) for the connections of the winding acting at the level of the plane of cutting.

10. The machine as claimed in any one of the preceding claims 5 through 9, characterized in that it furthermore comprises a station (5) for application of the delayed cure adhesive on printed circuits (2) and an adhesive curing station (5).

**Patentansprüche**

1. Automatisches Verfahren zur Fertigung und Anbringung von Wicklungen ohne Wicklungskörperträger auf einer gedruckten Schaltung, dadurch gekennzeichnet, daß die Düse (12) zum Wickeln des Drahtes den Wicklungsdraht um einen ersten, einen Teil einer Wicklungstrommel (11, 11A) bildenden festen Punkt, dann um eine Spindel (14) mit geeignetem Durchmesser, um die ihn die Düse wickelt, und dann um einen zweiten, ebenfalls einen Teil der Trommel bildenden festen Punkt führt, wobei der gegenseitige Abstand dieser zwei festen Punkte dem Mittenabstand der geradlinigen Enden der Wicklung zum Einsetzen in die gedruckte Schaltung, die auch als Anschlüsse der Wicklung bezeichnet werden, entspricht, wobei der Abstand jeder dieser beiden in bezug auf die Spindel etwas größer als die Länge der Anschlüsse der herzustellenden Wicklung ist und wobei ihre Anordnung in bezug auf die Spindel derart ist, daß diese Anschlüsse über ihre gesamte Länge parallel zueinander sind, daß ein Schneide- und Transportwerkzeug die Anschlüsse der Wicklung bei der gewünschten Länge zwischen der Spindel und den zwei festen Punkten mittels Scherschneiden schneidet und dabei den in der Scherschneidezone gespannten Draht unbeweglich hält, daß das Werkzeug die Wicklung von der Spindel abnimmt und daß ein Handhabungsautomat die Spule an ihren Anschlüssen aufnimmt und dann die Enden der Anschlüsse in die entsprechenden Löcher der gedruckten Schaltung einsetzt.

2. Verfahren gemäß Anspruch 1, dadurch gekennzeichnet, daß auf der gedruckten Schaltung zwischen den Einsetzlöchern für die Anschlüsse einer Wicklung vor dem Anbringen der Wicklung ein Klebepunkt angebracht wird.

3. Verfahren gemäß Anspruch 2, dadurch gekennzeichnet, daß der Kleber vom Typ mit verzögertem Abbinden ist, dessen Abbinden nach der Anbringung sämtlicher Wicklungen ohne Wicklungskörperträger auf der gedruckten Schaltung ausgelöst wird.

4. Verfahren gemäß Anspruch 3, dadurch gekennzeichnet, daß der Kleber ein warmabbindender oder ein ultraviolett abbindender Kleber ist.

5. Automatische Maschine zur Fertigung und zur Anbringung von Wicklungen ohne Wicklungskörperträger auf einer gedruckten Schaltung, gekennzeichnet durch wenigstens eine Wicklungsstation (7, 8) mit einer Wicklungsdüse und einer Trommel (11, 11A) mit Wicklungsspindeln (14), wobei jede Spindel zwei an festen Punkten angeordneten, einen Teil der Trommel bildenden Vorrichtungen (15) zugeordnet ist, eine bewegliche Vorrichtung zum Schneiden des Drahtes und zum Transport (13), deren Schneideebene jeweils zwischen einer Spindel und den zwei zugehörigen festen Punkten angeordnet ist, und einen Automaten zur Handhabung und zum Einsetzen der Wicklungen (9), der die Wicklungen an ihren geradlinigen Enden, die auch Anschlüsse genannt werden, aufnimmt.

6. Maschine gemäß Anspruch 5, dadurch gekennzeichnet, daß die Vorrichtungen fester Punkte koplanare Flügel (oder Steckstellen) (15) sind, die sich senkrecht zur Mittellinie der Trommel um deren Umfangsfläche erstrecken.

7. Maschine gemäß Anspruch 6, dadurch gekennzeichnet, daß jeder Flügel (oder jede Steckstelle) eine erste in der Nähe der Umfangsfläche der Trommel ausgebildete und den Ort des ersten Anschlusses der Wicklung festlegende Vertiefung zur Führung des Drahtes (16) und eine zweite, von der Umfangsfläche der Trommel weiter entfernte und den Ort des zweiten Anschlusses der Wicklung festlegende Vertiefung zur Führung des Drahtes (17) und eine Vorrichtung zum Halten des Drahtes umfaßt.

8. Maschine gemäß einem der Ansprüche 5 bis 7, dadurch gekennzeichnet, daß sich die Düse zum Wickeln des Drahtes (12) parallel zur Mittellinie der Trommel bewegen kann.

9. Maschine gemäß einem der Ansprüche 5 bis 8, dadurch gekennzeichnet, daß die Vorrichtung zum Schneiden des Drahtes eine Vorrichtung (31, 34, 35) zum Festspannen der Anschlüsse der Wicklung umfaßt, die auf Höhe der Schneideebene wirkt.

10. Maschine gemäß einem der Ansprüche 5 bis 9, dadurch gekennzeichnet, daß sie außerdem einen Platz zum Aufbringen eines Klebers mit verzögertem Abbinden auf den gedruckten Schaltungen (2) und einen Platz zum Abbinden des Klebers (5) umfaßt.

# FIG_1

6.1  6.3  6.5  6.7  6.9  6.11  6.13

7  8  9  3  2  10  4  5  1

6.2  6.4  6.6  6.8  6.10  6.12  6.14

EP 0 236 213 B1

# FIG_2-B

# FIG_2-A

# FIG_2-C

# FIG_2-D

# FIG_3

# FIG_4

# FIG_5